# NEUE EUROPÄISCHE PATENTSCHRIFT

(11) **EP 3 066 431 B2**
(45) Veröffentlichungstag und Bekanntmachung des Hinweises auf die Entscheidung über den Einspruch: **06.09.2023**
(45) Hinweis auf die Patenterteilung: 03.01.2018
(21) Anmeldenummer: 14786807.9
(22) Anmeldetag: 22.10.2014
(51) Int. Cl.: G01G 21/28, G01G 23/48, G01G 17/04

(54) **DOSIERVORRICHTUNG MIT INTEGRIERTER WAAGE UND KLIMAMODUL**
DOSING DEVICE COMPRISING INTEGRATED WEIGHING SCALES AND CLIMATE MODULE
DISPOSITIF DE DOSAGE AVEC BALANCE ET MODULE DE CLIMATISATION INTÉGRÉS

(30) Priorität: 08.11.2013 DE 102013018767; 07.02.2014 DE 102014101561
(43) Veröffentlichungstag der Anmeldung: 14.09.2016
(73) Patentinhaber: Sartorius Lab Instruments GmbH & Co. KG, 37079 Göttingen (DE)
(72) Erfinder: BAUMFALK, Reinhard, 37083 Göttingen (DE); KIRCHHOFF, Rainer, 37197 Hattorf (DE); BERTOLDI, Jean-Claude, 37079 Göttingen (DE)
(74) Vertreter: Prinz & Partner mbB
(86) Internationale Anmeldenummer: PCT/EP2014/002854
(87) Internationale Veröffentlichungsnummer: WO 2015/067351

(56) Entgegenhaltungen:
- EP-A1- 1 975 577
- EP-A1- 2 251 657
- WO-A1-2013/163612
- DE-A1-102010 042 621
- DE-U1-202004 000 590

## Beschreibung

Die Erfindung betrifft eine Dosiervorrichtung, mit der flüssige und/oder feste Stoffe in einem vorgegebenen Mischungsverhältnis, also gemäß einer vorgegebenen Rezeptur, mit hoher Genauigkeit zusammengeführt werden können.

Dosieraufträge nach vorgegebener Rezeptur von flüssigen und/oder festen Stoffen werden häufig auf Waagen ausgeführt. Dabei werden die Rezepturen in der Regel aus Datenbanken entweder statisch (feste Rezeptur) oder dynamisch (formelbasierte Rezeptur) generiert.

Die EP 1 975 577 A1 zeigt eine Waage zur gravimetrischen Kalibrierung von Pipetten, die über einen Windschutz und eingebaute Temperatur-, Luftdruck- und Luftfeuchtesensoren verfügt.

Aus der DE 44 07 433 C2 ist eine Waage zum Dosieren bekannt, mit deren Hilfe es möglich ist, innerhalb einer Rezeptur bei Fehldosierung einzelner Komponenten eine Korrektur der Dosierung der restlichen Komponenten vorzunehmen. Nachteilig ist, dass beim Dosieren der Einzelkomponenten nur der prozentuale Masseanteil der Einzelkomponenten betrachtet wird.

Selbst bei einer dynamischen Rezeptur werden allerdings nicht die aktuellen Umgebungsbedingungen (Temperatur, Feuchte, Zeit, ...) am Ort und zum Zeitpunkt der Dosierung berücksichtigt, sodass die Rezeptur eventuell nicht den Anforderungen der nachfolgenden Verwendung genügt.

Ein Beispiel hierfür sind Mischungen mit flüchtigen Bestandteilen, deren Anteil in nachfolgenden Verarbeitungsschritten in Abhängigkeit von der am Wägeort herrschenden Verdunstungsrate, die maßgeblich von der Lufttemperatur und der Luftfeuchte bestimmt wird, variiert. Dies betrifft zum Beispiel Flüssigkeitsgemische mit Alkoholanteilen. Umgekehrt ist beispielsweise der Einfluss von Klimaparametern beim Dosieren von hygroskopischen Stoffen als Bestandteil einer Rezeptur von Bedeutung, insbesondere der Einfluss von Lufttemperatur und Luftfeuchte.

Ein weiteres Beispiel sind Mischungen, deren Viskosität von der Umgebungstemperatur abhängt und bei späteren Prozessschritten einen gegebenen Zielwert haben sollte, beispielsweise Backmischungen mit variablem Fett- oder Wassergehalt. Hier wäre es wünschenswert, dass die Rezeptur entsprechend der aktuellen und lokalen Umgebungsbedingungen korrigiert wird und somit zur benötigten Viskositätswert für Knet- oder Formprozesse führt.

Außerdem haben die Umgebungsbedingungen bei nachfolgenden Verarbeitungsschritten Auswirkungen auf das Endergebnis. Beispielsweise wirkt sich die Umgebungsfeuchte bei Lackmischungen aus, die aufgesprüht werden, da der Trocknungsvorgang und Aushärtungsprozess durch die Umgebungsfeuchte bedingt unterschiedlich schnell verläuft. Wenn hier unabhängig von der Umgebungsfeuchte dieselbe Aufbringungsqualität erhalten werden soll, ist ein daran angepasster Anteil an Lösungsmittel notwendig.

Die Aufgabe der Erfindung besteht darin, eine Dosiervorrichtung mit integrierter Waage dahingehend weiterzubilden, dass ein vorgegebene Rezeptur auf Basis von vor Ort und zeitnah bestimmten Umgebungsparametern korrigiert werden kann.

Zur Lösung dieser Aufgabe ist erfindungsgemäß eine Dosiervorrichtung, die ausgebildet ist, flüssige und/oder feste Stoffe in einem vorgegebenen Mischungsverhältnis mit hoher Genauigkeit zusammenzuführen , mit einer Waage vorgesehen, die einen Wägeraum aufweist, einen Prozessor, ein Klimamodul, das einen Luftdrucksensor, einen Luftfeuchtesensor und einen Lufttemperatursensor enthält und abnehmbar im Wägeraum angeordnet ist, eine Datenübertragungsstrecke, die ausgebildet ist, Daten zwischen dem Klimamodul und dem Prozessor auszutauschen, und mit einer Anzeigeneinheit. Die Erfindung beruht auf dem Grundgedanken, unmittelbar in der Dosiervorrichtung mittels des Klimamoduls die Klimaparameter zu erfassen, die eine Auswirkung auf die Bemessung beziehungsweise Dosierung der zusammenzuführenden Stoffe hat. In Abhängigkeit von den erfassten Klimaparametern kann dann die angewendete Rezeptur geeignet korrigiert werden. Dadurch können zum einen die Auswirkungen der Klimabedingungen auf den Dosiervorgang als solchen kompensiert werden, beispielsweise temperaturbedingte Abweichungen bei der volumenbasierten Dosierung. Es ist auch möglich, die Auswirkungen der Umgebungsbedingungen auf den von der Waage ermittelten Wägewert zu kompensieren, beispielsweise temperaturbedingte Messfehler. Insgesamt lässt sich auf diese Weise gewährleisten, dass eine vorgegebene Rezeptur sehr viel genauer eingehalten wird.

Gemäß einer Ausführungsform ist vorgesehen, dass das Klimamodul mittels einer elektrischen Steckverbindung mit dem Prozessor verbunden ist. Die Steckverbindung kann in eine mechanische Aufnahme integriert sein, die zur Anbringung des Klimamoduls an der Präzisionswaage dient. Auf diese Weise wird die Datenübertragungsstrecke zum Prozessor automatisch dann erstellt, wenn das Klimamodul innerhalb des Windschutzes an seinem Platz angeordnet wird. Gemäß einer alternativen Ausführungsform ist vorgesehen, dass das Klimamodul drahtlos mit dem Prozessor gekoppelt ist. In diesem Fall kann das Klimamodul an einer beliebigen Stellen innerhalb des Windschutzes oder dem Chassis der Waage angeordnet werden, beispielsweis an einer Seitenwand, an der es am wenigsten stört, ohne dass darauf Rücksicht genommen werden muss, ob an dieser Stelle sinnvoll eine Steckverbindung angeordnet werden kann. Außerdem ist der Verzicht auf eine Steckverbindung dahingehend vorteilhaft, dass der Innenraum der Wägekabine glatter und damit bessere reinigbar ausgeführt werden kann.

Gemäß einer bevorzugten Ausführungsform der Erfindung ist vorgesehen, dass die Waage eine Präzisionswage ist, die einen Windschutz aufweist, der den Wägeraum umgibt. Diese Ausführungsform ist besonders geeignet, wenn Kleinstmengen mit besonders hoher Präzision zusammengeführt werden sollen, beispielsweise mit einer Genauigkeit im Bereich von Milligramm oder Mikrogramm.

Gemäß einer weiteren Ausführungsform der Erfindung steht die Waage in einer Wägekabine mit einem begrenzten Volumen. In diesem Fall verfügt sie nicht über einen separaten Windschutz. Diese Ausführungsform ist geeignet für die Abarbeitung von Mischungaufträgen im Lackmischbereich. Beispiele hierfür sind Nachbestellungen von Lack zur Reparatur von beispielsweise Steinschlägen bei Kraftfahrzeugen, bei denen nur sehr geringe Mengen verwendet werden. Diese werden basierend auf der Originalrezeptur hergestellt, wobei bei der jeweils angewendeten individuellen Rezeptur berücksichtigt werden kann, welchen Alterungsgrad der zu ergänzende Lack tatsächlich hat.

Der besondere Vorteil dieser Ausführungsform besteht darin, dass sämtliche Bauteile und Funktionen, die für eine Klimakompensation von Wägewerten nötig sind, in der Dosiervorrichtung mit der Präzisionswaage vereinigt werden. Es sind daher keine externen Computer, Sensoren, etc. notwendig. Stattdessen kann dem Benutzer eine kompakte Dosiervorrichtung an die Hand gegeben werden, die sogar transportabel ausgeführt sein kann. Da das Klimamodul austauschbar (also zerstörungsfrei von der Waage lösbar) ist, kann es nach Bedarf zu einem externen Institut bzw. Dienstleister zum Kalibrieren geschickt werden. In der Zwischenzeit kann die Dosiervorrichtung weiter betrieben werden, indem ein Austausch-Klimamodul eingesetzt wird. Es kann also immer rollierend eines oder (bei mehreren Dosiervorrichtungen) mehrere der Klimamodule beim Kalibrieren sein, während mit den übrigen Klimamodulen gemessen wird.

Hinsichtlich der Genauigkeit hat die erfindungsgemäße Dosiervorrichtung mit Präzisionswaage den Vorteil, dass die Klimaparameter im Windschutz oder in einer die Waage unmittelbar umgebende Wägekabine gemessen werden.. Es kann somit die Verdunstungsrate unmittelbar am Wägeort ermittelt und ein entsprechender Korrekturfaktor zur Verfügung gestellt werden. Das Klimamodul enthält einen Luftdrucksensor, einen Luftfeuchtesensor und einen Lufttemperatursensor. Mit diesen Sensoren können die für eine präzise Messung wesentlichen Klimadaten aufgenommen werden.

Gemäß einer Ausführungsform ist eine Dosiervorrichtung vorgesehen, die ausgebildet ist, elektronisch gesteuert zu werden. Dies ermöglicht es, den Mischvorgang automatisiert vorzunehmen, ohne dass ein Bediener die zusammenzuführenden Stoffe einzeln abwiegen muss. Dadurch werden die Fehlerquellen vermieden, die sich aus einem manuellen Einwirken eines Bedieners ergeben.

Gemäß einer Weiterbildung kann eine Behandlungsvorrichtung vorgesehen sein, die ausgebildet ist, mindestens einen der zusammenzuführenden Stoffe zu behandeln, beispielsweise erwärmt oder gekühlt. Mit dieser Ausgestaltung können die zusammenzuführenden Stoffe im Hinblick auf ein optimales Ergebnis, also insbesondere im Hinblick auf ein möglichst präzises Befolgen der vorgegebenen Rezeptur, konditioniert werden, da die Dichte, die Viskosität, etc. zum Zeitpunkt des Dosierens Auswirkungen auf die Dosiergenauigkeit haben. Durch das Konditionieren ist gewährleistet, dass die physikalischen Eigenschaften der zusammenzuführenden Stoffe denjenigen entsprechen, die beim Aufstellen der Rezeptur zugrunde gelegt wurden.

Gemäß einer Ausführungsform verfügt das Klimamodul über einen elektronischen Speicher, insbesondere ein EEPROM, der von außen auslesbar ist und auf dem Kalibrierwerte und Korrekturwerte für das Klimamodul abgelegt werden können. Zum Justieren können die Kalibrierwerte und Korrekturwerte auf dem elektronischen Speicher auf dem Klimamodul abgelegt werden, insbesondere auf einem EEPROM. Dies kann bei einem externen Dienstleister geschehen. Wenn das Klimamodul dann wieder an die Präzisionswaage angekoppelt wird, stehen diese Daten dem Prozessor der Waage unmittelbar zur Verfügung. Zusätzlich können auf dem Speicher unter anderem zumindest einige der folgenden Informationen zur Sensorkalibrierung abgelegt werden: Nummer des Kalibrierscheins, aktuelle Kalibrierwerte, Kalibrierdatum, Name des Kalibrierlabors und des Bearbeiters sowie Kalibrierhistorie. Auf dem Speicher des Klimamoduls können auch sogenannte Unsicherheitswerte für jede Klimagröße abgelegt sein, sodass diese für eine Berechnung der Gesamtunsicherheit des Messergebnisses zur Verfügung stehen, welche dann für eine Ausgabe in einem Protokoll zur Verfügung stehen können.

Gemäß einer Ausgestaltung ist vorgesehen, dass das Klimamodul auch außerhalb einer Waage als selbständige Einheit einsetzbar ist und über einen I²C-Bus an einen USB-Port eines PC anschließbar ist. Dies erleichtert das externe Kalibrieren. Außerdem kann das Klimamodul in anderen Anwendungen dafür eingesetzt werden, Klimaparameter aufzunehmen, ohne dass es an eine Waage angeschlossen ist. Die Leiterplatte des Klimamoduls kann hierfür mit geringem Aufwand einen Steckfortsatz aufweisen, um an einen USB-Adapter angeschlossen werden zu können.

Zur Lösung der oben genannten Aufgabe ist auch ein Verfahren zum Dosieren einer Rezeptur unter Verwendung einer Dosiervorrichtung der vorstehend erläuterten Art vorgesehen, wobei während des Dosierens der zusammenzuführenden Stoffe Umgebungsbedingungen erfasst und anhand der Umgebungsbedingungen das Mischungsverhältnis einer Rezeptur direkt oder indirekt angepasst wird. Hierzu werden an Hand der erfassten einzelnen Klimaparameter, insbesondere der Lufttemperatur, Luftdruck und der Luftfeuchte Korrekturfaktoren für die einzelnen Rezepturbestandteile ermittelt, die einer Datenbank entnommen werden. Diese Datenbank kann entweder direkt in einem Speicher der Waage abgelegt sein oder sich auf einem externen Speicherort (z.B. Datenbankserver) befinden, mit dem die Waage über eine Datenleitung oder drahtlos verbunden ist. Hinsichtlich der sich ergebenden höheren Genauigkeit des Dosiervorgangs wird auf die obigen Erläuterungen verwiesen.

Gemäß einer Ausgestaltung des erfindungsgemäßen Verfahrens ist vorgesehen, dass die Parameter der Umgebungsbedingungen dafür verwendet werden, einen Wägewert eines der zusammenzuführenden Stoffe zu korrigieren. Bei dieser Ausgestaltung wird der unmittelbare Einfluss von Klimaparametern auf den Wägewert kompensiert, also beispielsweise der Einfluss von sich ändernden Klimaparametern auf das Verhalten der Wägezelle oder der Einfluss von unterschiedlich hohem Luftdruck auf den Auftrieb des Wägeguts.

Gemäß einer anderen Ausgestaltung des erfindungsgemäßen Verfahrens ist vorgesehen, dass die Parameter der Umgebungsbedingungen dafür verwendet werden, einen Dosierparameter der zusammenzuführenden Stoffe zu korrigieren. Die Umgebungsbedingungen wirken sich nämlich auch darauf aus, mit welcher Genauigkeit die zusammenzuführenden Stoffe dosiert werden können. Temperaturänderungen können zu einer Änderung der Viskosität der zu dosierenden Stoffe führen. Temperaturänderungen führen auch zu einer unterschiedlichen Dichte, was sich bei einer volumenbasierten Dosierung in unterschiedlichen Mengen bemerkbar macht. Schließlich kann der unmittelbare Einfluss der Umgebungsbedingungen auf die Dosieranlage selbst kompensiert werden.

Gemäß einer Variante des erfindungsgemäßen Verfahrens ist vorgesehen, dass die Umgebungsbedingungen dafür verwendet werden, mindestens einen der zusammenzuführenden Stoffe vor dem Zusammenführen vorzubehandeln. Beispielsweise kann der zu behandelnde Stoff erwärmt oder gekühlt werden, sodass gewährleistet ist, dass sich die physikalischen Eigenschaften des zu dosierenden Stoffes innerhalb eines vorbestimmten Toleranzbereiches befinden. Ähnlich kann der Feuchtegehalt des zu dosierenden Stoffes in der gewünschten Weise angepasst werden, um ein optimales Dosierergebnis zu erhalten. Weiter kann über die Parameter Umgebungsfeuchte und Temperatur der Taupunkt bestimmt werden, der eine Mindesttemperatur für die Rezepturkomponenten vorgibt, um ungewollte Kondensationseffekte an den Rezepturkomponenten zu vermeiden. Schließlich kann vorgesehen sein, dass die Rezeptur an die späteren Verwendungsbedingungen der zusammengeführten Stoffe angepasst wird. In diesem Fall wird die angewendete Rezeptur anhand von Informationen modifiziert, welche die späteren Verwendungsbedingungen der zusammengeführten Stoffe näher charakterisieren. Für das Beispiel eines Lacks kann beispielsweise angegeben werden, ob dieser später unter hohen oder niedrigen Temperaturen aufgebracht wird oder bei einer eher hohen oder eher niedrigen Luftfeuchte. Entsprechend den Bedingungen beim Auftragen des Lacks kann dann der Lösungsmittelgehalt, etc. so angepasst werden, dass die gewünschte Viskosität und das gewünschte Trocknungsverhalten zu einem späteren Verarbeitungszeitpunkt gewährleistet sind. Ebenfalls ist über eine integrierte Zeitmessung ein bereits startender Verdunstungsprozess zu korrigieren, indem in Abhängigkeit von bekannten Verdunstungsraten, der gemessenen Dauer des Mischprozesses und der Kenntnis des Verarbeitungszeitpunktes, die Rezeptur angepasst wird.

Weitere Merkmale und Vorteile der Erfindung ergeben sich aus der nachfolgenden Beschreibung und aus den nachfolgenden Zeichnungen, auf die Bezug genommen wird. In den Zeichnungen zeigen:
- Figur 1 schematische Ansicht einer erfindungsgemäßen Dosiervorrichtung,
- Figur 2 eine Explosionsansicht einer Präzisionswaage, die in einer erfindungsgemäßen Dosiervorrichtung verwendet werden kann,
- Figur 3 eine Perspektivansicht eines Klimamoduls, das bei der in Figur 2 gezeigten Präzisionswaage eingesetzt werden kann,
- Figur 4 eine Seitenansicht des Klimamoduls nach Figur 3 ohne Außengehäuse, und
- Figur 5 eine Draufsicht auf das Klimamodul von Figur 3, ebenfalls ohne Außengehäuse.

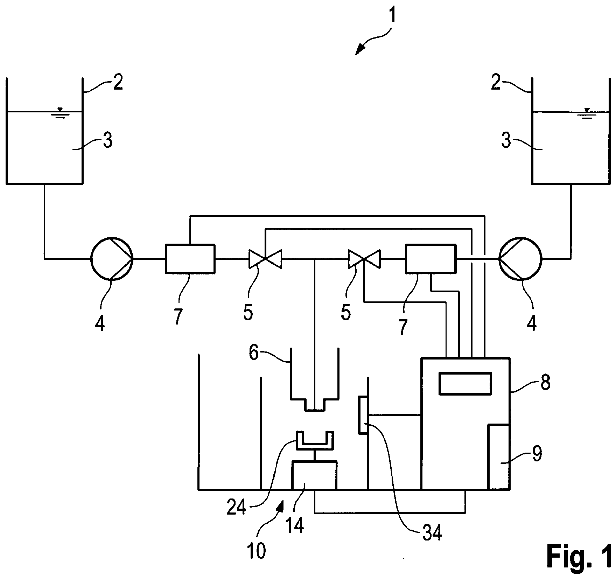

In Figur 1 ist schematisch eine Dosiervorrichtung 1 dargestellt, die zwei Vorratsbehälter 2 aufweist, in denen sich zu mischende Stoffe 3 befinden, beispielsweise flüssige oder feste Stoffe. Falls ein Lack gemischt wird, kann es sich beispielsweise um Farbpigmente, Füllstoffe und Lösungsmittel handeln.

Von den Vorratsbehältern 2 können die Stoffe 3 über Pumpen 4 und Dosierventile 5 hin zu einem Dosierkopf 6 befördert werden. Optional können Behandlungsvorrichtungen 7 vorgesehen sein, beispielsweise Kühlvorrichtungen oder Heizvorrichtungen, mit denen die Stoffe 3 behandelt werden können. Bei den Behandlungsvorrichtungen kann es sich auch um Trocknungs- oder Befeuchtungsvorrichtungen handeln.

Obwohl beim gezeigten Ausführungsbeispiel zwei Vorratsbehälter mit zwei Stoffen 3 vorgesehen sind, versteht es sich, dass grundsätzlich eine beliebige Anzahl von verschiedenen Stoffen mit der erfindungsgemäßen Dosiervorrichtung zusammengeführt werden kann.

Die Dosiervorrichtung 1 enthält weiterhin eine Steuerung 8, welche die verschiedenen Komponenten der Dosiervorrichtung (beispielsweise Pumpen 4 und Dosierventile 5) ansteuern kann.

In der Steuerung 8 ist auch in einem Speicher 9 ein Rezept hinterlegt, also das Mischungsverhältnis für die zusammenzuführenden Stoffe 3.

Teil der Dosiervorrichtung 1 ist außerdem eine Waage 10, die eine Waagschale 24 und eine Wägezelle 14 aufweist. Die Waagschale 24 ist so angeordnet, dass die zusammengeführten Stoffe 3 dort aufgebracht werden, sodass von der Wägezelle 14 die Gewichtskraft bestimmt werden kann. Die Gewichtskraft wird der Steuerung 8 zur Verfügung gestellt.

Wichtiger Bestandteil der Dosiervorrichtung 1 ist ein Klimamodul 34, das in der Waage 10 angeordnet ist und dort verschiedene Klimaparameter erfasst, insbesondere Temperatur, Luftdruck und Luftfeuchte. Diese Werte werden ebenfalls der Steuerung 8 zur Verfügung gestellt.

Die Steuerung 8 ist in der Lage, auf der Basis der Daten des Klimamoduls 34 ein dort hinterlegtes Rezept so anzupassen, dass die Auswirkungen des Mikroklimas in der Dosiervorrichtung 1 auf den aktuellen Mischvorgang möglichst optimal kompensiert werden.

In der Steuerung 8 sind geeignete Korrekturtabellen hinterlegt, anhand denen die Dosierparameter korrigiert und der Wägewert der Waage 10 korrigiert werden können.

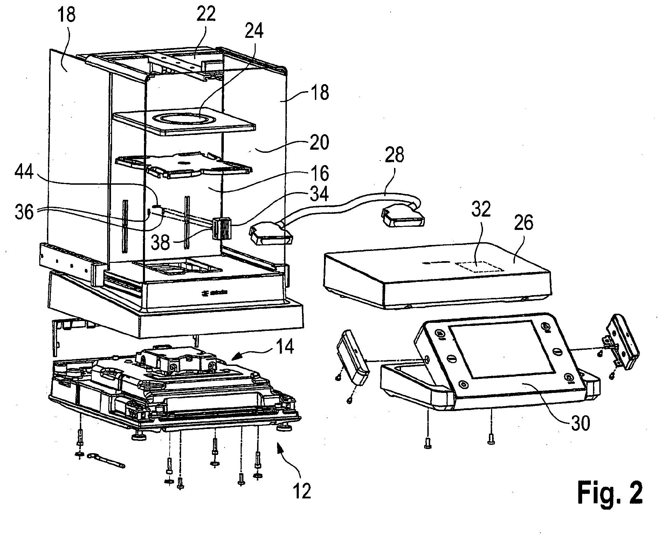

Wenn die Dosiervorrichtung 1 dazu verwendet wird, hochpräzise Rezepturen zu mischen, wird als Waage 10 eine Präzisionswaage verwendet. Ein Beispiel für eine solche Waage ist in den Figuren 2 bis 5 gezeigt. Zum Zwecke der besseren Übersichtlichkeit sind in diesen Figuren die weiteren Bauteile der Dosiervorrichtung, also beispielsweise der Dosierkopf und die Vorratsbehälter, nicht dargestellt.

In Figur 2 ist eine hochauflösende elektronische Waage (Präzisionswaage) dargestellt. Sie enthält eine Wägezelle 14 mit einer Basis 12, in welche ein nicht näher dargestelltes Wägesystem untergebracht ist. Die Waage 10 umfasst darüber hinaus einen Wägeraum 16, der durch einen Windschutz mit verstellbaren Seitenwänden 18, einer Frontwand 20 sowie einer Rückwand 22 ausgebildet ist. Über den Windschutz ist der Wägeraum 16 zur Umgebung abgetrennt. Eine Waagschale 24 dient zum Auflegen des Wägeguts, also der zusammenzuführenden Stoffe 3.

Eine hier als separates Teil ausgeführtes elektronisches Auswertesystem 26 ist über ein Kabel 28 mit der Wägezelle 14 elektronisch gekoppelt. Eine Anzeigeeinheit 30, die mit dem Auswertesystem 26 gekoppelt ist, dient sowohl als Anzeige- als auch als Dateneingabeeinheit.

Die Anzeigeeinheit 30 dient als Mischrezepturanzeige, auf der eine herzustellende Rezeptur angezeigt wird, insbesondere die einzelnen Stoffe in der Reihenfolge und Menge, in der sie vom Bediener abgewogen werden sollen.

Im elektronischen Auswertesystem 26 ist unter anderem ein Prozessor 32 untergebracht, der Daten von der Wägezelle 14 erhält.

Im Wägeraum 16 ist ein als baulich separate Einheit ausgeführtes Klimamodul 34 vorgesehen, welches über eine lösbare Steckverbindung mechanisch mit der Rückwand 22 koppelbar ist (also zerstörungsfrei lösbar angebracht ist), und zwar vorzugsweise ohne Zuhilfenahme eines Werkzeugs.

Hierzu weist die Rückwand 22 zwei von einander beabstandete Schlitze 36 auf, in die flexible Rasthaken 38 (siehe auch Figur 2) am Außengehäuse 40 des Klimamoduls einrasten.

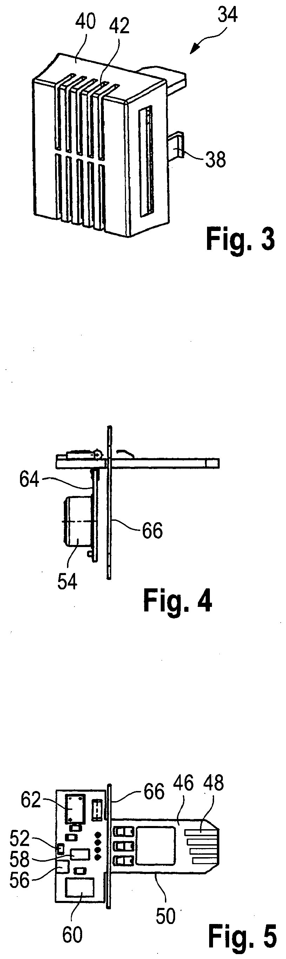

In den Figuren 3 bis 5 ist das Klimamodul 34 näher dargestellt.

Das Außengehäuse 40 hat zahlreiche Öffnungen 42, über die das Innere des Außengehäuses 40 in den Wägeraum 16 übergeht und Teil des Wägeraums 16 wird, sodass das Klima im Inneren des Wägeraums 16 dem im Inneren des Außengehäuses 40 entspricht.

Das Klimamodul 34 ist elektronisch über eine elektrische Steckverbindung mit einer entsprechenden Steckeraufnahme 44 in der Rückwand 22 gekoppelt. Die Steckeraufnahme 44 steht elektrisch mit dem Prozessor 32 in Verbindung. In die Steckeraufnahme 44 wird ein Stecker 46 mit Kontakten 48 am Klimamodul 34 eingesteckt. Somit bildet der Stecker 46 einen modulseitigen Teil der elektrischen Steckverbindung.

Alternativ zu einer elektrischen Steckverbindung kann eine drahtlose Übertragungsform, beispielsweise WLAN oder Bluetooth, verwendet werden.

Die elektrische Steckverbindung (oder die alternativ verwendete drahtlose Übertragung) bildet eine Datenübertragungsstrecke, mit der Daten vom Klimamodul 34 zum Prozessor 32 und ggfls. zurück übertragen werden können.

Der Stecker 46 ist vorzugsweise ein Abschnitt einer Leiterplatte 50, auf der mehrere Sensoren zum Erfassen des Klimas im Wägeraum 16 angeordnet sind. So sind ein Lufttemperatursensor 52, eine Luftfeuchtesensor 54, ein unmittelbar in der Nähe einer Öffnung 42 angeordneter Lichtsensor 56 sowie ein ggf. weitere Sensoren 58 auf der Leiterplatte 50 vorgesehen, ebenso wie ein elektronischer Speicher 60. Ein Luftdrucksensor 62 ist über eine Halterung 64 mit der Leiterplatte 50 mechanisch und elektrisch gekoppelt.

Mehrere der Sensoren können auch zu kombinierten Sensoren zusammengefasst sein.

Eine Wand 66 schließt das schalenartige Außengehäuse 40, sodass der schmale, zungenartige, in Figur 4 rechts von der Wand 66 liegende Abschnitt der Leiterplatte 50 in die Rückwand 22 und die Steckeraufnahme 44 einsteckbar ist.

Über entsprechende Kontakte 48 ist jeder Sensor mit dem Prozessor 32 gekoppelt. Ebenso ist der Speicher 60 mit dem Prozessor 32 gekoppelt.

Bei einem Wägevorgang kann die Dichte des Wägeguts in die Präzisionswaage eingegeben werden, beispielsweise über die Anzeigeeinheit 30, die gleichzeitig als Dateneingabeeinheit dient. Alternativ kann die Dichte des Wägeguts bereits hinterlegt sein.

Dann wird ein Wägegut auf die Waagschale 24 aufgebracht, also eine bestimmte Menge eines Stoffs gemäß der Rezeptur.

Der Luftdruck, die Luftfeuchte und die Lufttemperatur werden über die Sensoren 62, 54 bzw. 52 ermittelt, und die entsprechenden Daten werden an den Prozessor 32 weitergeleitet.

Im Prozessor 32 werden einzelne Klimaparameter verarbeitet und zum Beispiel die Verdunstungsrate bestimmt. Hieraus werden Korrekturfaktoren für die einzelnen Rezepturbestandteile ermittelt.

Darüber hinaus sind im Speicher 60 Kalibrierwerte und Korrekturwerte für das Klimamodul 34 abgelegt, die beim Kalibrieren des Klimamoduls 34 hinterlegt wurden.

Dieses Kalibrieren erfolgt außerhalb der Präzisionswaage. Hierzu wird das Klimamodul 34 einfach aus dem Wägeraum 16 entfernt, ohne dass eine Drahtverbindung gelöst werden muss. Das Klimamodul 34 wird dann zu einem entsprechenden Kalibrierinstitut geschickt, das die Sensoren entsprechend neu kalibriert und beispielsweise die Nummer des Kalibrierscheins, das Kalibrierdatum, den Namen des Kalibrierlabors und des Bearbeiters und die Kalibrierhistorie auf dem Speicher 60 ablegt. Die neu ermittelten Kalibrierwerte werden vom Applikationsprogramm später, wenn das Klimamodul 34 wieder in der Präzisionswaage angeordnet ist, ausgelesen und fließen direkt in die Berechnung ein.

Auch die Werte des Lichtsensors 56 und ggf. weiterer Sensoren 58 werden erfasst.

Beispielsweise wird bei erhöhtem Lichteinfall ein entsprechendes Signal auf der Anzeige angegeben werden, dass beispielsweise die Messung aufgrund erhöhter Sonneneinstrahlung und damit veränderter Temperatur im Wägeraum ungenau ist. Somit wird vom Prozessor ein Ausgangssignal abhängig vom Lichteinfall abgegeben.

Der Speicher 60 ist vorzugsweise ein EEPROM.

Die Verbindung zwischen dem Klimamodul 34 und der Präzisionswaage kann beispielsweise über einen I²C-BUS realisiert werden.

Das Klimamodul 34 kann über einen USB-Adapter, in den es eingesteckt wird, an einen Computer angeschlossen werden, um die Sensoren 52 bis 58 und 62 zu kalibrieren, ohne dass das Klimamodul 34 mit der Waage 10 in Verbindung stehen muss.

Wie zu erkennen ist, ist das Klimamodul so ausgebildet ist, dass es auch außerhalb einer Waage als selbständige Einheit einsetzbar ist und beispielsweise über einen I²C-Bus an einen PC anschließbar ist.

Mit einer solchen Präzisionswaage können Mischungsverhältnisse bzw. Rezepturen mit extrem hoher Genauigkeit eingehalten werden, wobei potentielle Einflussfaktoren, die auf das Mikroklima im Bereich der Dosiervorrichtung und insbesondere im Bereich der Waage 10 zurückgehen, kompensiert werden.

## Patentansprüche

1. Dosiervorrichtung, die ausgebildet ist, flüssige und/oder feste Stoffe in einem vorgegebenen Mischungsverhältnis mit hoher Genauigkeit zusammenzuführen, mit einer Waage, die einen Wägeraum (16) aufweist, einen Prozessor (32), ein Klimamodul (34), das einen Luftdrucksensor (62), einen Luftfeuchtesensor (54) und einen Lufttemperatursensor (52) enthält und abnehmbar im Wägeraum (16) angeordnet ist, eine Datenübertragungsstrecke, die ausgebildet ist, Daten zwischen dem Klimamodul (34) und dem Prozessor (32) auszutauschen, und einer Anzeigeeinheit (30).

2. Dosiervorrichtung nach Anspruch 1, **dadurch gekennzeichnet, dass** das Klimamodul (34) mittels einer elektrischen Steckverbindung oder einer Funkübertragung mit dem Prozessor (32) verbunden ist.

3. Dosiervorrichtung nach einem der vorhergehenden Ansprüche, **dadurch gekennzeichnet, dass** die Waage eine Präzisionswage ist, die einen Windschutz (18, 20, 22) aufweist, der den Wägeraum (16) umgibt.

4. Dosiervorrichtung nach einem der vorhergehenden Ansprüche, **dadurch gekennzeichnet, dass** ein Lichtsensor (56) im Wägeraum (16) vorhanden ist, welcher mit dem Prozessor (32) gekoppelt ist.

5. Dosiervorrichtung nach einem der vorhergehenden Ansprüche, **dadurch gekennzeichnet, dass** eine Dosiervorrichtung vorgesehen ist, die ausgebildet ist, elektronisch gesteuert zu werden.

6. Dosiervorrichtung nach einem der vorhergehenden Ansprüche, **dadurch gekennzeichnet, dass** eine Behandlungsvorrichtung vorgesehen ist, die ausgebildet ist, mindestens einen der zusammenzuführenden Stoffe zu behandeln.

7. Verfahren zum Mischen einer Rezeptur unter Verwendung einer Dosiervorrichtung nach einem der Ansprüche 1 bis 6, bei dem während des Dosierens der zusammenzuführenden Stoffe Umgebungsbedingungen erfasst und anhand der Umgebungsbedingungen das Mischungsverhältnis direkt oder indirekt angepasst wird.

8. Verfahren nach Anspruch 7, **dadurch gekennzeichnet, dass** die Umgebungsbedingungen dafür verwendet werden, einen Dosierparameter der zusammenzuführenden Stoffe zu korrigieren.

9. Verfahren nach einem der Ansprüche 7 und 8, **dadurch gekennzeichnet, dass** die Umgebungsbedingungen dafür verwendet werden, mindestens einen der zusammenzuführenden Stoffe vor dem Zusammenzuführen zu behandeln.

10. Verfahren nach einem der Ansprüche 7 bis 9, **dadurch gekennzeichnet, dass** die Rezeptur an die späteren Verwendungsbedingungen der zusammengeführten Stoffe angepasst wird.

## Claims

1. Dosing device constructed to combine liquid and/or solid substances in a predetermined mixture ratio with a high level of accuracy, comprising a weighing machine having a weighing space (16), a processor (32), an air conditioning module (34) which includes an air pressure sensor (62), a humidity sensor (54) and an air temperature sensor (52) and is removably arranged in the weighing space (16), a data transmission path configured to exchange data between the air conditioning module (34) and the processor (32), and a display unit (30).

2. Dosing device according to claim 1, **characterised in that** the air conditioning module (34) is connected with the processor (32) by means of an electrical plug connection or radio transmission means.

3. Dosing device according to one of the preceding claims, **characterised in that** the weighing machine is a precision weighing machine having a wind protector (18, 20, 22) surrounding the weighing space (16).

4. Dosing device according to any one of the preceding claims, **characterised in that** a light sensor (56), which is coupled with the processor (32), is present in the weighing space (16).

5. Dosing device according to any one of the preceding claims, **characterised in that** a dosing device constructed to be electronically controlled is provided.

6. Dosing device according to any one of the preceding claims, **characterised in that** a treatment device constructed to treat at least one of the substances to be combined is provided.

7. Method for mixing a composition with use of a dosing device according to any one of claims 1 to 6, in which environmental conditions are detected during dosing of the substances to be combined and the mixture ratio is directly or indirectly adapted on the basis of the environmental conditions.

8. Method according to claim 7, **characterised in that** the environmental conditions are used for the purpose of correcting a dosing parameter of the substances to be combined.

9. Method according to one of claims 7 and 8, **characterised in that** the environmental conditions are used for the purpose of treating at least one of the substances, which are to be combined, prior to the combining.

10. Method according to any one of claims 7 to 9, **characterised in that** the composition is adapted to the later use conditions of the combined substances.

## Revendications

1. Dispositif de dosage, qui est conçu pour réunir des substances liquides et/ou solides selon un rapport de mélange prédéfini à une vitesse accrue, pourvu d'une balance qui comporte une chambre de pesée (16), un processeur (32), un module de climatisation (34), lequel contient un capteur de pression d'air (62), un capteur d'humidité d'air (54) et un capteur de température d'air (52) et lequel est agencé dans la chambre de pesée (16) de manière amovible, une ligne de transmission de données, qui est conçue pour échanger des données entre le module de climatisation (34) et le processeur (32), et une unité d'affichage (30).

2. Dispositif de dosage selon la revendication 1, **caractérisé en ce que** le module de climatisation (34) est relié au processeur (32) au moyen d'une connexion électrique ou d'une transmission radio.

3. Dispositif de dosage selon l'une quelconque des revendications précédentes, **caractérisé en ce que** la balance est une balance de précision qui comporte un pare-vent (18, 20, 22) entourant la chambre de pesée (16).

4. Dispositif de dosage selon l'une quelconque des revendications précédentes, **caractérisé en ce qu'**un capteur de lumière (56) est présent dans la chambre de pesée (16) et est couplé au processeur (32).

5. Dispositif de dosage selon l'une quelconque des revendications précédentes, **caractérisé en ce qu'**un dispositif de dosage est prévu, qui est conçu pour être commandé électroniquement.

6. Dispositif de dosage selon l'une quelconque des revendications précédentes, **caractérisé en ce qu'**un dispositif de traitement est prévu, qui est conçu pour traiter au moins l'une des substances à réunir.

7. Procédé de mélange d'une recette au moyen d'un dispositif de dosage selon l'une quelconque des revendications 1 à 6, selon lequel, pendant le dosage des substances à réunir, les conditions ambiantes sont détectées et le rapport de mélange est adapté directement ou indirectement en fonction des conditions ambiantes.

8. Procédé selon la revendication 7, **caractérisé en ce que** les conditions ambiantes sont utilisées pour corriger un paramètre de dosage des substances à réunir.

9. Procédé selon l'une quelconque des revendications 7 et 8, **caractérisé en ce que** les conditions ambiantes sont utilisées pour traiter au moins l'une des substances à réunir avant de réunir lesdites substances.

10. Procédé selon l'une quelconque des revendications 7 à 9, **caractérisé en ce que** la recette est adaptée aux conditions d'utilisation ultérieures des substances réunies.
